# EUROPEAN PATENT APPLICATION

(11) **EP 0 909 036 A1**
(43) Date of publication of application: **14.04.1999**
(21) Application number: 98402468.7
(22) Date of filing: 06.10.1998
(51) Int. Cl.: H03L 7/189, H03L 7/099

(54) **Phase locked loop circuit**

(30) Priority: 07.10.1997 GB 9721135
(71) Applicant: NEC CORPORATION, Tokyo (JP)
(72) Inventor: Tolson, Nigel James, Reading, Berkshire RG3 5NW (GB); Rostbakken, Olaf, NEC Technologies LTD., Reading, Berkshire RG2 0TD (GB)
(74) Representative: Signore, Robert

(57) **Abstract**

This invention relates to a phase locked loop circuit for use in multi-frequency radio communication system. In accordance with the invention, there is provided a phase locked loop circuit comprising a voltage controlled oscillator including a voltage controlled variable impedance semiconductor device, a programmable frequency divider connected to the output of the oscillator, a phase detector connected to the output of the frequency divider and a reference frequency source, a filter circuit connecting to output of the phase detector to a first input of the oscillator at one side of said semiconductor device, an external controller, first means connecting said first input of the oscillator to the controller and second means connecting an output of the controller to a second input of the oscillator at the other side of said semiconductor device, said controller acting to vary the voltage at said second input of the oscillator independently of the loop voltage variations applied to said first input of the oscillator.

## Description

This invention relates to a phase locked loop circuit particularly, but not exclusively intended for use in multi-frequency radio communications systems.

Conventionally, the resonant frequency of the voltage controlled oscillator in a PLL circuit has to be manually calibrated in order to obtain the required output frequency range for the valid loop voltage range. Furthermore, where fast switching between different frequencies is required, the conventional arrangement which tracks the loop voltage is inadequate.

It is an object of the present invention to provide a phase locked loop circuit in which these difficulties are overcome in a simple and economical manner.

In accordance with the invention, there is provided a phase locked loop circuit comprising a voltage controlled oscillator including a voltage controlled variable impedance semiconductor device, a programmable frequency divider connected to the output of the oscillator, a phase detector connected to the output of the frequency divider and a reference frequency source, a filter circuit connecting to output of the phase detector to a first input of the oscillator at one side of said semiconductor device, an external controller, first means connecting said first input of the oscillator to the controller and second means connecting an output of the controller to a second input of the oscillator at the other side of said semiconductor device, said controller acting to vary the voltage at said second input of the oscillator independently of the loop voltage variations applied to said first input of the oscillator.

Preferably the controller is a cpu, said first means includes a sampling switch and an analog to digital converter, and said second means comprises a digital to analog converter and a sample and hold circuit.

The cpu is used during calibration of the oscillator to determine an adjustment voltage which must be applied to the semiconductor device during operation to correct the operating range of the vco.

The cpu is also used to promote fast switching between operating frequencies, by applying a predetermined voltage to the semiconductor element for each required operating frequency.

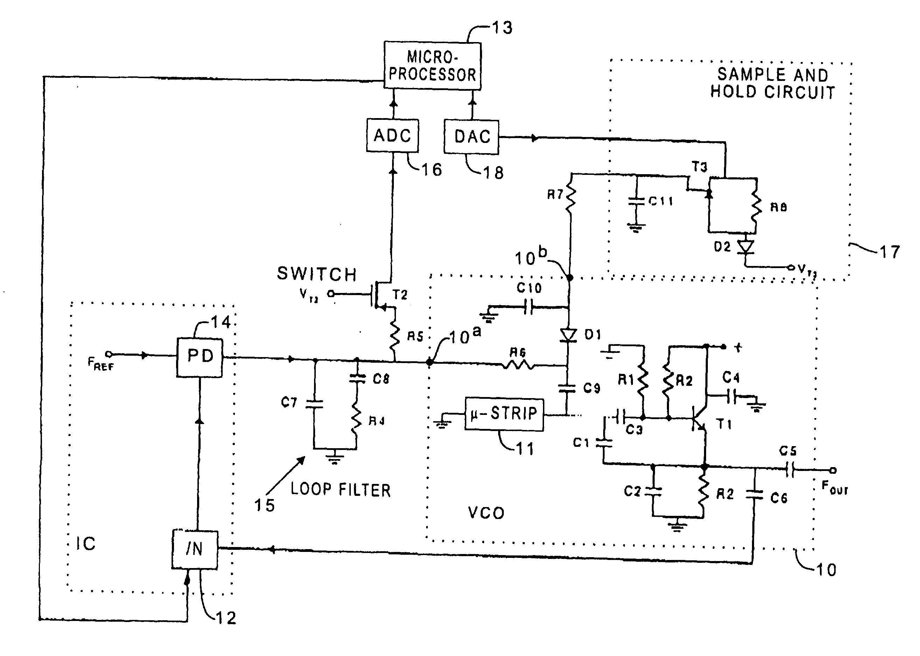

An example of the invention is shown in the sole figure of the accompanying drawings which is a circuit diagram of an example of a phase locked loop circuit in accordance with the invention.

The voltage controlled oscillator **10** of the circuit includes a voltage controlled variable impedance semiconductor device in the form of a varactor diode **D1**. This has its cathode connected to a first input terminal **10a** via a resistor **R6** and its anode connected to a second input terminal **10b.** A capacitor **C9** couples the anode of the varactor diode **D1** to a microstrip resonator circuit **11** and to an amplifier based on transistor **T1**.

The output of the amplifier is connected to a programmable frequency divider **12** which is controlled by a cpu **13**. The output of the frequency divider and a reference frequency signal are applied in well known manner to a phase detector circuit **14**, the output of which is applied via a filter circuit **15** to the first input **10a** of the vco.

The circuit thus far described can operate in the conventional manner with the loop stabilising when the vco output divided down by the frequency divider is in a predetermined phase relationship with the reference frequency.

The cpu **13**, also acts as a controller for calibration of the oscillator and speeding up its response to step changes in the target frequency set by the setting of the frequency divider **12**. To this end, a sampling switch, in the form of an fet **T2** is connected to the first input **10a** of the oscillator. This switch connected this input **10a** to an analog to digital converter **16** which provides input to a port of the cpu **13.** Furthermore a sample and hold circuit **17** is provided to apply a voltage signal to the second input **10b** of the vco. This sample and hold circuit receives an analog input from a digital to analog converter **18** connected to a port of the cpu.

The cpu can thus modify the behaviour of the vco by applying a variable voltage when required to the anode of the varactor diode independently of any variations which may be occurring in the voltage arriving at the vco first input **10a** via the feedback loop.

This is used for autocalibration of the vco. The loop filter voltage is sampled using the switch **T2** and the digital value representing the loop filter voltage is supplied to the cpu by the a/d converter **16**. The cpu outputs an adjustment voltage by comparing the sampled loop filter voltage with a desired voltage level for a given channel. The adjustment voltage is applied to the sample and hold circuit by the d/a converter **18** and, as a result a correction voltage is applied to the anode of the varactor diode. In this way, the need for any laser or mechanical trimming operation during manufacture is completely avoided.

The cpu is also used to modify the performance of the vco during switching between frequencies. For this purpose, as part of the initialisation of the system at switch on three frequencies are accessed at the top, bottom and in the middle of the frequency range of the oscillator. For each of these frequencies, the loop filter voltage is sampled and stored. These values are used by a conventional linear interpolation algorithm which calculates the voltage to be supplied to the sample and hold circuit for each discrete frequency required. This substantially reduces the time required for the vco to achieve stable operation at its target frequency after a step change in frequency is commanded.

Where the vco has a non-linear characteristic such that the calculation algorithm referred to above is insufficiently accurate, the initialisation routine will test all the required frequency channels and the cpu will store the voltage value for each frequency in a look up table which is consulted whenever a frequency change is needed.

## Claims

1. A phase locked loop circuit comprising a voltage controlled oscillator including a voltage controlled variable impedance semiconductor device, a programmable frequency divider connected to the output of the oscillator, a phase detector connected to the output of the frequency divider and a reference frequency source, a filter circuit connecting the output of the phase detector to a first input of the oscillator at one side of said semiconductor device, an external controller, first means connecting said first input of the oscillator to the controller and second means connecting an output of the controller to a second input of the oscillator at the other side of said semiconductor device, said controller acting to vary the voltage at said second input of the oscillator independently of the loop voltage variations applied to said first input of the oscillator.

2. A phase locked loop circuit as claimed in claim 1 in which the controller is a cpu.

3. A phase locked loop circuit as claimed in claim 2 in which said first means comprises an analog to digital converter and a sampling switch connecting said first input to the analog to digital converter.

4. A phase locked loop circuit as claimed in claim 2 in which said second means comprises a digital to analog converter and a sample and hold circuit for receiving the output of the converter and applying a corresponding voltage to said second input of the oscillator.

5. A phase locked loop circuit as claimed in any of claims 2 to 4 in which said cpu operates to determine the voltage levels to be applied to said second input of the oscillator for each of a plurality of discrete frequencies and acts to apply the appropriate voltage level when a change in operating frequency is demanded so as to speed up settling of the oscillator at the new operating frequency.
